# EUROPEAN PATENT SPECIFICATION

(11) **EP 0 467 997 B1**
(45) Date of publication and mention of the grant of the patent: **29.01.1997**
(21) Application number: 90911162.7
(22) Date of filing: 11.04.1990
(51) Int. Cl.: G01R 29/10

(54) **METHOD AND MEANS FOR NEAR FIELD ANTENNA MONITORING**
VORRICHTUNG UND VERFAHREN ZUR ÜBERWACHUNG MIT EINER ANTENNE IN NAHFELD
PROCEDE ET MOYEN DE CONTROLE AVEC UNE ANTENNE A CHAMP PROCHE

(30) Priority: 13.04.1989 US 339560
(43) Date of publication of application: 29.01.1992
(73) Proprietor: HAZELTINE CORPORATION, Greenlawn New York 11740 (US)
(72) Inventor: FELDMAN, Paul, Hyman, Commack, NY 11725 (US); GENCORELLI, Joseph, Benett, Lindenhurst, NY 11757 (US); LOPEZ, Alfred, Raymond, Commack, NY 11725 (US); SCHAY, Gary, Anthony, Stony Brook, NY 11790 (US)
(74) Representative: Whalley, Kevin
(86) International application number: US9002081
(87) International publication number: WO9012327

(56) References cited:
- US-A- 3 604 010
- US-A- 3 879 733
- US-A- 4 468 669
- US-A- 4 661 820
- US-A- 4 788 552
- Electronics Letters, Vol. 13, No. 8, 14 April 1977 (14.04.77), K.M. KEEN, "Simulation of a Proposed Near-Field-to Far-Field Antenna Measurement System" pp. 225 - 226.

## Description

### BACKGROUND OF THE INVENTION

This invention relates to near field antenna monitoring systems generally and, more particularly, to a novel method and means which allows a monitor in the near field to receive a signal approximating that which the monitor would receive if located in the far field.

While the present invention is described as being especially useful with near field antenna monitors for microwave landing systems (MLS) for aircraft, it will be understood by those skilled in the art that it has other useful applications as well.

Part of a typical MLS is concerned with angle guidance for aircraft, which is accomplished through the use of two electronically scanned microwave antenna arrays - one for azimuth and the other for elevation. Distance is measured by a third element not of concern here. Because of the criticality of the application, each antenna is continuously monitored in the field in real time to measure the quality of the microwave beam. Ideally, the beam should be monitored in the far fields where it is focused, that is, a distance from the antenna of at least 2D²/λ, wherein D = aperture of the transmitting device and λ = wavelength of the transmitted signal, all in feet or corresponding metric units. For a 1 degree beamwidth antenna, this distance is approximately 427 meters (1400 feet).

In many cases, it is impractical to locate monitors in the far field; however, locating the monitor in the near field where the transmitted beam is unfocused can result in unacceptable performance, primarily due to phase errors and due to the magnification of the effects of system design tolerances. While somewhat acceptable results can be obtained with monitors located about 91 meters (300 feet) from the antenna, there is considerable room for improvement. Also, in some cases, even that distance is impractical and it would be desirable to be able to locate the monitor closer, say, perhaps as close as 24-27 meters (80-90 feet) and still be able to obtain acceptable results.

In the prior art, far field signal approximations have been derived from near field signals in antenna measurement systems which typically require use of complex computer processing of signals or use of sophisticated beam-forming networks, or both, and which, as a result, are not practical for use as antenna monitoring systems. For example, patent document SU-A-1,462,212, publication date February 28, 1989, which discloses the features of the preambles of Claim 1 and 3 respectively, describes a complex system in which signals received by groups of twelve probes spaced along a semi-circle equidistant from a test antenna provide signals for antenna measurement purposes. The probe signals are processed through circulators, Butler multiport beam forming matrices, attenuators, phase shifters, microwave summators, mixers and directional couplers in order to carry out forward and reverse Fourier transforms. Calibration of the system requires operation with a testing antenna with a known directional pattern. Patent document SU-A-1,377,770, publication date February 29, 1988, discloses a probe in the form of a waveguide formed into a semi-circle and pivoted at its ends on an axis passing through the throat of a horn antenna to be tested. Signals are received through a series of slots and coupled out via a single exciting pin extending into the waveguide. The waveguide is rotated for measurements at different azimuth angles. Use for making single-probe measurements is referred to, without disclosure of how measurement signals may be processed to derive far field data. Electronics Letters, Vol. 13, No. 8, 14 April 1977, pages 225-226, which discloses the features of the preambles of Claims 2 and 4 respectively, describes simulation of a proposed near-field-to-far-field antenna measurement system based upon extraction of phase information from interference patterns. An antenna under test is positioned by a 2-axis positioner while signals are received by a single fixed antenna. Sets of four patterns are recorded, three being interference patterns, over the entire spherical envelope and in two orthagonal polarizations and from each set a phase distribution and an amplitude distribution are extracted by data processing. The resulting phase and amplitude information can be processed by a near-field-to-far-field-transformation computer program referenced, but not described in the article. These examples are considered representative of prior art approaches relying upon the use of complex computational programs, typically employing Fourier transformation techniques, and make no mention of simplified systems suitable for practical application in monitoring operational antenna systems.

It is, therefore, an object of the present invention to provide a method and means for locating an antenna monitor in the near field relatively close to the antenna while obtaining acceptable monitoring.

It is an additional object of the invention to provide such means that may comprise only passive components, for reliability.

It is another object of the invention to provide such method and means that can be easily and simply applied without consuming a great deal of space.

The present invention provides a monitoring system, for monitoring, in the near field, the signal from a transmitting antenna by use of monitor means and modifying means located in the near field for receiving said signal from said transmitting antenna and inputting to said monitor means a signal approximating that which would be received in the far field, said monitoring system including antenna element means for coupling components of said transmitted signal and modifying means for modifying some of said signal components and providing a combined signal which is passed to said monitor means, said antenna element means comprising
a first antenna element, supported at a position on a reference axis which is normal to the transmitting antenna, for coupling near field on-axis signals components radiated along said reference axis,
a plurality of other antenna elements, supported at positions symmetrically spaced off said reference axis, for coupling near field off-axis signals radiated at a separation from said reference axis, and
said modifying means being arranged for subjecting said off-axis signal components to selected relative phase modification values with respect to the on-axis signal components and combining said on-axis and said modified off-axis signal components to provide said far field signal approximation without use of either a computer-based Fourier transformation or a Butler matrix type beam-forming network, wherein said monitoring system is arranged for use with a transmitting antenna which provides an antenna beam scanned across said first and other antenna elements and wherein either
said modifying means is a power divider and said other antenna elements lie along a line, which is parallel to said transmitting antenna and which intersects said reference axis at the position of said first antenna element on said reference axis and said power divider also modifies the amplitudes of said off-axis signal components: or
said modifying means consists of two waveguide sections and said first and said other antenna elements consist of only three radiating elements, each in the form of a similar set of slots in a portion of waveguide, where said other antenna elements lie along a line which is parallel to said transmitting antenna and which intersects said reference axis at a position which is different from the position of said first antenna element and are equally spaced from said first antenna element by said waveguide sections effective to provide predetermined phase modification values and arranged to couple signals from said other antenna elements to signals from said first antenna element, whereby the antenna elements form a standing-wave antenna, which provides the combined signal in said first antenna element.

The present invention also provides a monitoring system as defined by claim 2 and a method for monitoring as defined by claims 3 and 4.

### BRIEF DESCRIPTION OF THE DRAWINGS

Fig. 1 is a schematic diagram of a field monitor system employing a sampling array according to a first embodiment of the present invention.

Fig. 2 is a perspective view of an azimuth focusing array according to a second embodiment of the present invention.

Fig. 3 is a perspective view of an elevation focusing array according to a second embodiment of the present invention.

Fig. 4 is a schematic diagram of a field monitor system according to a third embodiment of the present invention.

Fig. 5 is a block flow diagram illustrating the operation of the signal processor of the embodiment of Fig. 4.

Figure 6 is a block flow diagram illustrating the operation of an element of the signal processor of Fig. 5.

### DETAILED DESCRIPTION OF THE INVENTION

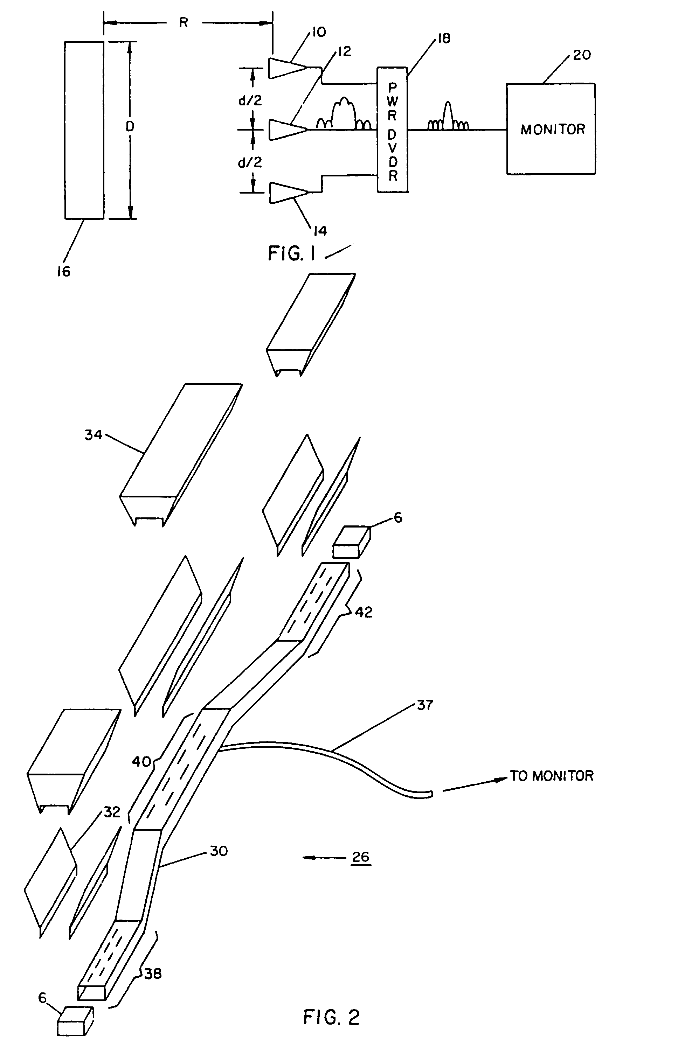

Fig. 1 shows a schematic diagram of a field monitor system employing a first type of sampling array according to the present invention which may be assumed to be located in the near field and which includes three, equally spaced conventional antenna elements 10, 12, and 14 disposed in a line parallel to the major axis of an antenna 16 which is being monitored, with the center element aligned with the center of the transmitting antenna. When antenna 16 is an elevation antenna, it may be assumed that Fig. 1 is an elevation view. When antenna 16 is an azimuth antenna, it may be assumed that Figure 1 is a plan view. It will be understood that both elevation and azmuth antennas would be provided in a monitoring installation.

The signals received by antenna elements 10-14 are combined in power divider 18 of the type that is used with transmitting antennas, it being understood that elements of transmitting/receiving systems have reciprocal functions. Power divider 18 causes the signals from antenna elements 10 and 14 to be one half amplitude and lag that from antenna element 12 by 120 degrees, assuming the signal from antenna element 12 is at zero phase. The combined signal from power divider 18 is passed to monitor 20 which "sees" a signal approximating that which it would receive if the system were located in the far field.

As seen in Fig. 1, antenna elements 10 and 14 are spaced apart from antenna element 12 by a distance d/2. It has been found that acceptable results can be obtained with the embodiment shown when d = (2/3)(λ/sin θ) and R = D²/(3λ), wherein λ = wavelength of the transmitted signal, R is the distance between the transmitting antenna 16 and antenna element 12, and θ = the angle formed oetween the center and the edge of the transmitting antenna 16 as viewed from antenna element 12. Vhere θ = arctan (D/2R) It follows that d = 40/9. When for example, the transmitting antenna aperture D is 3.66 meters (12 feet), and the wavelength of the signal is 5.926 cm (2.333 inches), d = 162.6 cm (64 inches) and R = 75.26 meters (246.9 feet). As noted above, acceptable results are obtained with three antenna elements; however, additional elements to improve the quality of the signal produced can be provided within the intent of the present invention by those skilled in the art.

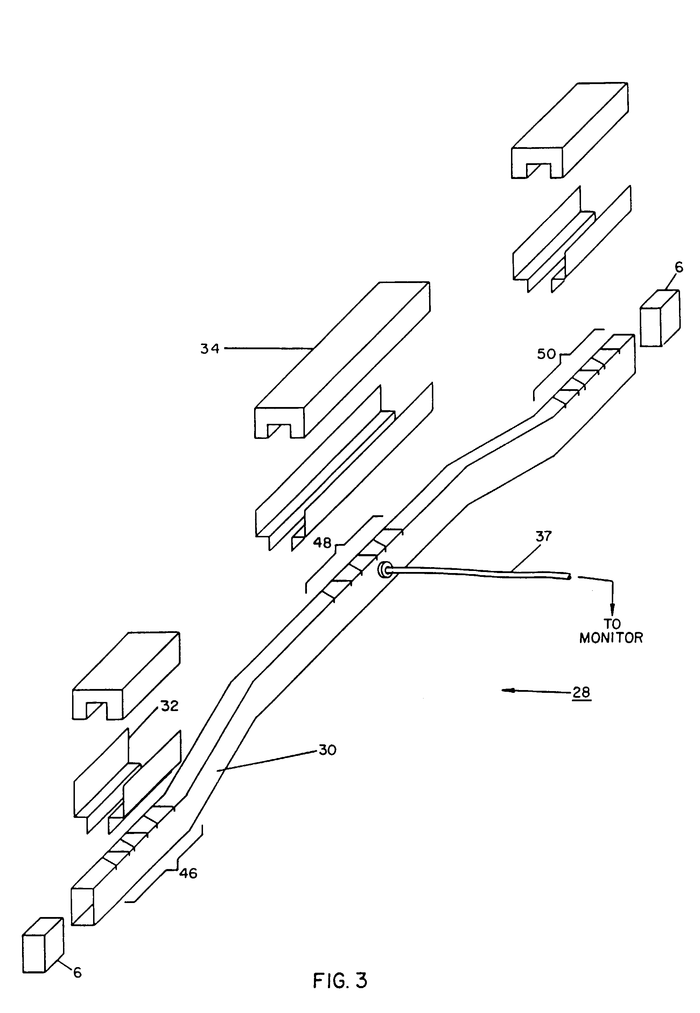

While the present invention may be practiced, as described above, with three separate antenna elements feeding a power divider, it is preferable to use an antenna array which may employ a standing wave, but with which a power divider cannot cause the necessary phase shift. Antenna arrays employing standing waves are shown in perspective view in Figs. 2 and 3 wherein antennas are illustrated for azimuth and elevation arrays, respectively, and wherein like elements are given like identifying reference numerals in both figures.

Each antenna array, generally indicated by the reference numeral 26 or 28, includes a rectangular waveguide 30, flare elements, as at 32, closed cell foam blocks for weather protection, as at 34, and adjustable short circuit blocks 6 at each end of waveguide 30 for obtaining optimum performance. A coaxial cable 37 attached to the broad side of waveguide 30 connects the array to the monitor (not shown).

Azimuth antenna array 26 (Fig. 2) includes three elements 38, 40, 42 formed as shown, with elements 38, 40, and 42, each having seven or less radiating slots, all slots being formed in a broad side of waveguide 30. Elevation antenna array 28 (Fig. 3) includes three elements 46, 48, and 50 formed as shown, with each element having seven or less radiating slots formed in a narrow side of waveguide 30. With both arrays 26 and 28, the outermost elements are spaced apart from the center element by a distance d/2 determined by the formula discussed above with reference to the arrangement shown in Fig. 1, i.e., d = (2/3)(λ/sinθ).

As can be seen from inspection of Figs. 2 and 3, the outermost elements are offset in a greater degree from the transmitting antenna (not shown) than the center element by bends in the waveguides 30 to provide phase lag which cannot be attained using a power divider with a standing wave antenna. A standing wave antenna is preferred, as it provides for a high degree of phase stability. It has been found, that with the configuration shown, the offset is preferably chosen-so that, when the center element is at zero phase, the outer elements each lag in phase by 105 degrees. The necessary offset to provide this phase lag is 1.73 cm (0.68 inches).

As noted above, blocks 34 are closed cell foam. The other elements of antenna arrays 26 and 28 are preferably and conveniently formed from aluminum sheet.

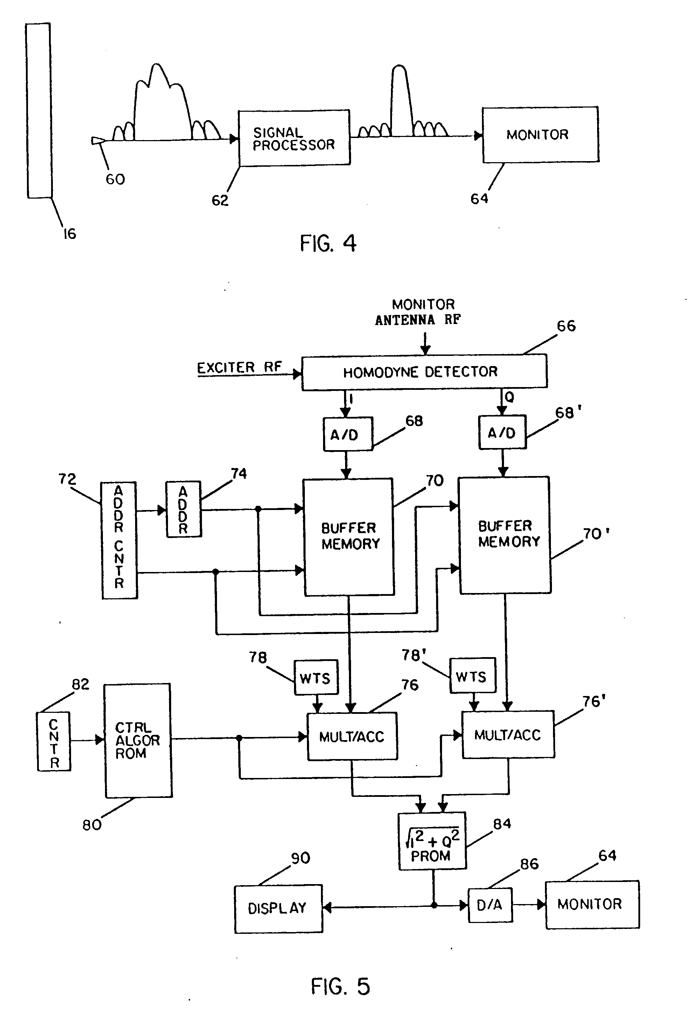

Fig. 4 shows schematically another embodiment of the present invention, this one electronically "focusing" the signal received in the near field. Here, a beam from transmitting antenna 16 is received by monitoring antenna 60 which may be of any conventional type. As with reference to the discussion above in connection with Fig. 1, antenna 16 may be viewed as either an azimuth or elevation antenna. Monitoring antenna 60 passes the received unfocused signal pattern to a signal processor 62 which provides as its output a focused signal pattern as would be received by a monitoring antenna located in the far field, which focused signal pattern is the input to monitor 64.

Fig. 5 is a block flow diagram of signal processor 62 of Fig. 4 which receives the unfocused antenna signal and produces a signal approximating a focused signal. A homodyne detector 66 receives as inputs the monitor antenna RF signal and the exciter RF signal from the transmission system. The in-phase ("I") and quadrature ("Q") outputs of homodyne detector 66 are converted to digital signals by analog/digital converters 68 and 68', respectively, which produce bits of sample information approximately every 2 microseconds. The data bits from A/D converters 68 and 68' are stored in buffer memories 70 and 70', respectively, which may be lKx8 RAMs. An adder/counter 72 and an adder 74 serve as a circular counter to sequentially address the data bits in buffer memories 70 and 70', and pass the data to multiplier/accumulators 76 and 76', respectively, where, in moving groups, they are sequentially multiplied by sets of weights 78 and 78', respectively, under an algorithm stored in a PROM 84 and initiated by a counter 82. The outputs from multiplier/accumulators 76 and 76' pass to a PROM 84 where they are combined in the function shown. The output of PROM 84 passes to a digital/analog converter 86 and thence to monitor 64. If desired, the digital output of PROM 84 may be fed to a digital display 90.

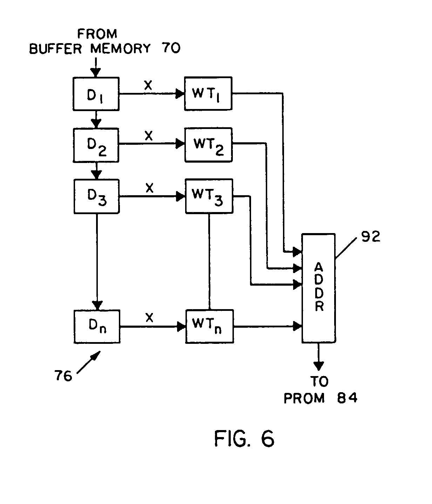

Fig. 6 diagrammatically illustrates the function of multiplier/accumulators 76 and 76' in which a moving stream of data bits from a buffer memory, in this case buffer memory 70, for example, enters multiplier /accumulator 76 and is multiplied by weighting factors, with the products summed in adder 92 and inputted to PROM 84. The weighting factors are chosen such that the final analog signal to monitor 64 (Fig. 5) will approximate that which it would receive in the far field.

With the embodiment of the present invention shown on Figs. 4-6, one should be able to obtain satisfactory results with a monitor installation in the near field at least as close to the transmiting antenna as 24-27 meters (80-90 feet) and possibly as close as 18 meters (60 feet). Monitoring antenna locations closer than 18 meters (60 feet) would probably not be satisfactory, as the processing time of about 250-400 microseconds would become a significant part of the response time of the monitor. At farther distances, the processing time is small compared to the response time and the effect thereof is less significant.

## Claims

1. A monitoring system, for monitoring, in the near field, the signal from a transmitting antenna (16) by use of a monitor means (20) and modifying means (18; 30) located in the near field for receiving said signal from said transmitting antenna and inputting to said monitor means a signal approximating that which would be received in the far field, said monitoring system including antenna element means (10, 12, 14; 38, 40, 42) for coupling components of said transmitted signal and modifying means (18; 30) for modifying some of said signal components and providing a combined signal which is passed to said monitor means, said antenna element means (10,12,14;38,40,42) comprising
a first antenna element (12; 40), supported at a position on a reference axis which is normal to the transmitting antenna (16), for coupling near field on-axis signal components radiated along said reference axis;
a plurality of other antenna elements (10, 14; 38, 42), supported at positions symmetrically spaced off said reference axis, for coupling near field off-axis signals radiated at a separation from said reference axis; and
said modifying means (18; 30) being arranged for subjecting said off-axis signal components to selected relative phase modification values with respect to the on-axis signal components and combining said on-axis and said modified off-axis signal components to provide said far field signal approximation, said monitoring system being characterised in that it is arranged for use with a transmitting antenna which provides an antenna beam scanned across said first and other antenna elements and in that said modifying means (18;30) provides said far field signal approximation without use of either a computer-based Fourier transformation or a Butler matrix type beam-forming network;
and by one of the following:
(a) said modifying means is a power divider (18) and said other antenna elements (10, 14) lie along a line, which is parallel to said transmitting antenna (16) and which intersects said reference axis at the position of said first antenna element (12) on said reference axis, and said power divider (18) also modifies the amplitudes of said off-axis signal components; or
(b) said modifying means consists of two waveguide sections (30) and said first (40) and said other antenna elements (38, 42) consist of only three radiating elements, each in the form of a similar set of slots in a portion of waveguide, where said other antenna elements (38, 42) lie along a line which is parallel to said transmitting antenna (16) and which intersects said reference axis at a position which is different from the position of said first antenna element (40) and are equally spaced from said first antenna element (40) by said waveguide sections (30) effective to provide predetermined phase modification values and arranged to couple signals from said other antenna elements (38, 42) to signals from said first antenna element (40), whereby the antenna elements (38, 40, 42) form a standing-wave antenna, which provides the combined signal in said first antenna element (40).

2. A monitoring system, for monitoring, in the near field, the signal from a transmitting antenna (16) by use of monitor means (64) and modifying means (62) located in the near field for receiving said signal from said transmitting antenna and inputting to said monitor means a signal approximating that which would be received in the far field, said monitoring system including antenna element means (60) for coupling said transmitted signal and modifying means (62) for modifying and combining components of said signal to said monitor means, wherein
said antenna element means (60) for coupling near field signals are positioned on a reference axis which is normal to the transmitting antenna (16); and
said modifying means (62) is arranged for subjecting components of said signals to selected modification values and thereafter combining said signal components to provide said far field signal approximation; and
said antenna element means consist of a single antenna element (60), said system is arranged for use with a transmitting antenna (16) which provides an antenna beam scanned across said antenna element (60), and said modifying means comprises signal processor means (62) said monitoring system being characterised in that said modifying means (62) is arranged to provide the far field approximation without use of either a computer-based Fourier transformation or a Butler matrix type beam-forming network and in that said signal processor means (62) provides said modification values by time-based processing and weighting of signal components, followed by combination of said signal components in a square root of the sum of the squares relationship, wherein said signal processor means (62) receives RF signals from said antenna element (60) and the exciter RF signal and separates the in-phase and the quadrature components which are weighted and combined in said square root of the sum of the squares relationship to provide said signal approximating the far field signal.

3. A method for near field region monitoring of the performance of a transmitting antenna (16), comprising the steps of:
(a) positioning, along a reference axis which is normal to the transmitting antenna (16) a first antenna element (12; 40) at a location within the near field region of said antenna (16);
(b) positioning, in spaced relationship to said reference axis, a plurality of additional antenna elements (10, 14; 38, 42) transversely and symmetrically spaced from said first antenna element (12;40);
(c) receiving, via said first and additional antenna elements, signals radiated by said antenna to be tested;
(d) modifying signals received by each of said additional antenna elements (10, 14; 38, 42), by a phase modification value, said phase modification value being the same for the signals from each of said additional antenna elements (10, 14; 38, 42);
(e) combining said signals from said first antenna element (12;40) and said modified signals from each of said additional antenna elements (10, 14; 38, 42) to provide a resultant received signal which approximates the signal which would be received in the far field; and
(f) monitoring (20) said resultant received signal;
said method characterized by one of the following:
(1) step (b) includes positioning said plurality of additional antenna elements (10, 14) along a line, which is parallel to said transmitting antenna (16) and which intersects said reference axis at the position of said first antenna element and step (d) includes modifying said signals by use of a power divider (18)which also modifies the amplitudes of the signals from each of said additional antenna elements (10, 14) by a modification value; or
(2) step (b) includes positioning two additional antenna elements each in the form of a similar set of slots in a portion of waveguide (38, 42) along a line, which is parallel to said transmitting antenna (16) and which intersects said reference axis at a different position than said first identical antenna element (40) and providing waveguide sections (30) effective to couple signals from said other antenna elements (38, 42) to signals from said first antenna element (40), such that the antenna elements (38, 40, 42) form a standing-wave antenna, and step (d) includes providing predetermined phase modification values.

4. A method for near field region monitoring of the performance of a transmitting antenna (16), comprising the steps of:
(a) positioning antenna element means (60) at a location within the near field region of said antenna (16),
(b) receiving, via said antenna element means (60), RF signals radiated by said antenna to be tested;
(c) modifying said components of said signals received by said antenna element means (60), by selected modification values and combining said signal components to provide a resultant received signal which approximates the signal which would be received in the far field; and
(d) monitoring said resultant received signal;
said antenna element means consisting of a single antenna element (60) arranged for use with a transmitting antenna (16) which provides an antenna beam scanned across said antenna element (60) said method being characterised in that step (b) comprises receiving the exciter RF signal from the transmission system and separating the in-phase and the quadrature components of the signals received by said antenna means (60) and in that the modification of said signal components comprises their time-based processing and weighting and thereafter combining the weighted signal components in a square root of the sum of the squares relationship.

## Patentansprüche

1. Überwachungssystem zur Nahfeldüberwachung des Signals von einer Sendeantenne (16) unter Verwendung einer Überwachungseinrichtung (20) und einer Modifizierungseinrichtung (18; 30), die sich im Nahfeld befindet, zum Empfangen des Signals von der Sendeantenne und zum Eingeben eines Signals. das sich dem nähert, das im Fernfeld empfangen werden würde, in die Überwachungseinrichtung, wobei das Überwachungssystem aufweist: eine Antennenelementeinrichtung (10, 12, 14; 38, 40, 42) zum Koppeln von Komponenten des übertragenen Signals und eine Modifizierungseinrichtung (18; 30) zum Modifizieren einiger der Signalkomponenten und zum Bereitstellen eines kombinierten Signals, das an die Überwachungseinrichtung weitergeleitet wird, wobei die Antennenelementeinrichtung (10, 12, 14; 38, 40, 42) aufweist:
ein erstes Antennenelement (12; 40), das in einer Position auf einer Referenzachse angeordnet ist, die für die Sendeantenne (16) normal ist, zum Koppeln von axialen Nahfeldsignalkomponenten, die entlang der Referenzachse abgestrahlt werden;
mehrere andere Antennenelemente (10, 14; 38, 42), die in Positionen angeordnet sind, die von der Referenzachse symmetrisch beabstandet sind, zum Koppeln von außeraxialen Nahfeldsignalen, die in einem Abstand von der Referenzachse abgestrahlt werden; und
wobei die Hodifizierungseinrichtung (18; 30) so eingerichtet ist, daß die außeraxialen Signalkomponenten gewählten relativen Phasenmodifikationswerten in bezug auf die axialen Signalkomponenten ausgesetzt werden und die axialen und die modifizierten außeraxialen Signalkomponenten kombiniert werden, um die Fernfeldsignalnäherung durchzuführen,
wobei das Überwachungssystem dadurch gekennzeichnet ist, daß es zur Verwendung mit einer Sendeantenne eingerichtet ist, die einen Antennenstrahl liefert. der über das erste und die anderen Antennenelemente geführt wird, und daß die Modifizierungseinrichtung (18; 30) die Fernfeldsignalnäherung weder unter Verwendung einer computergestützten Fourier-Transformation noch eines Butler-Matrix-Strahlbildungsnetzes durchführt, und durch eines von folgendem:
(a) die Modifizierungseinrichtung ist ein Leistungsteiler (18), und die anderen Antennenelemente (10, 14) liegen entlang einer Linie, die parallel zu der Sendeantenne (16) ist und die die Referenzachse an der Position des ersten Antennenelements (12) auf der Referenzachse schneidet und der Leistungsteiler (18) modifiziert außerdem die Amplituden der außeraxialen Signalkomponenten; oder
(b) die Modifizierungseinrichtung besteht aus zwei Wellenleiterteilen (30), und das erste (40) und die anderen Antennenelemente (38. 42) bestehen aus lediglich drei Strahlelementen, jedes in Form eines gleichen Satzes von Schlitzen in einem Abschnitt des Wellenleiters, wobei die anderen Antennenelemente (38, 42) entlang einer Linie liegen, die parallel zu der Sendeantenne (16) ist und die die Referenzachse an einer Position schneidet, die sich von der Position des ersten Antennenelements (40) unterscheidet, und gleichmäßig vom ersten Antennenelement (40) durch die Wellenleiterteile 30 beabstandet sind, die so wirksam sind, daß vorbestimmte Phasenmodifikationswerte bereitgestellt werden, und so eingerichtet sind, daß Signale von den anderen Antennenelementen (38, 42) mit Signalen von dem ersten Antennenelement (40) gekoppelt werden, wodurch die Antennenelemente (38, 40, 42) eine Stehwellenantenne bilden, die das kombinierte Signal im ersten Antennenelement (40) bereitstellt.

2. Überwachungssystem zur Nahfeldüberwachung des Signals von einer Sendeantenne (16) unter Verwendung einer Überwachungseinrichtung (64) und einer Modifizierungseinrichtung (72), die sich im Nahfeld befindet, zum Empfangen des Signals von der Empfangsantenne und zum Eingeben eines Signals, das sich dem nähert, das im Fernfeld empfangen werden würde, in die Überwachungseinrichtung, wobei das Überwachungssystem aufweist: eine Antennenelementeinrichtung (60) zum Koppeln des empfangenen Signals und eine Modifizierungseinrichtung (64) zum Modifizieren und Kombinieren von Komponenten des Signals für die Überwachungseinrichtung, wobei
die Antennenelementeinrichtung (60) zum Koppeln von Nahfeldsignalen auf einer Referenzachse positioniert ist, die zur Sendeantenne (16) normal ist; und
die Modifizierungseinrichtung (62) so eingerichtet ist, daß Komponenten der Signale gewählten Modifikationswerten ausgesetzt werden und danach die Signalkomponenten kombiniert werden, um die Fernfeldsignalnäherung durchzuführen: und
die Antennenelementeinrichtung aus einem einzelnen Antennenelement (60) besteht, das System zur Verwendung mit einer Sendeantenne (16) eingerichtet ist, die einen Antennenstrahl liefert, der über das Antennenelement (60) geführt wird, und die Modifizierungseinrichtung eine Signalprozessoreinrichtung (62) aufweist,
wobei das Überwachungssystem dadurch gekennzeichnet ist, daß die Modifizierungseinrichtung (62) so eingerichtet ist, daß die Fernfeldnäherung weder unter Verwendung einer computergestützten Fourier-Transformation noch eines Butler-Matrix-Strahlbildungsnetzes durchgeführt wird und daß die Signalprozessoreinrichtung (62) die Modifikationswerte durch zeitlich festgelegte Verarbeitung und Wichtung von Signalkomponenten bereitstellt, gefolgt von einer Kombination der Signalkomponenten auf der Grundlage einer Quadratwurzel der Summe der Quadrate. wobei die Signalprozessoreinrichtung (62) HF-Signale von dem Antennenelement (60) und das Strahler-HF-Signal empfängt und die Gleichphasen- und die Quadraturkomponenten trennt, die gewichtet und auf der Grundlage der Quadratwurzel der Summe der Quadrate kombiniert werden, um das Signal bereitzustellen, das sich dem Fernfeldsignal nähert.

3. Verfahren zur Nahfeldbereichsüberwachung der Leistung einer Sendeantenne (16), mit folgenden Schritten:
(a) Positionieren eines ersten Antennenelements (12; 40) in einer Position innerhalb des Nahfeldbereichs der Antenne (16) entlang einer Referenzachse, die zur Sendeantenne (16) normal ist;
(b) Positionieren mehrerer zusätzlicher Antennenelemente (10, 14: 38, 42) quer und von dem ersten Antennenelement (12; 40) symmetrisch beabstandet und in einem Abstandsverhältnis zu der Referenzachse;
(c) Empfangen von Signalen, die von der zu prüfenden Antenne abgestrahlt werden, über das erste und die zusätzlichen Antennenelemente;
(d) Modifizieren von Signalen, die von jedem der zusätzlichen Antennenelemente (10, 14; 38, 42) empfangen werden, mit einem Phasenmodifikationswert, wobei der Phasenmodifikationswert für die Signale von jedem der zusätzlichen Antennenelemente (10, 14; 38, 42) der gleiche ist;
(e) Kombinieren der Signale von dem ersten Antennenelement (12; 40) und der modifizierten Signale von jedem der zusätzlichen Antennenelemente (10, 14; 38, 42), um ein resultierendes Empfangssignal bereitzustellen, das sich dem Signal nähert, das im Fernfeld empfangen werden würde; und
(f) Überwachen (20) des resultierenden Empfangssignals;
wobei das Verfahren gekennzeichnet ist durch eines von folgendem:
(1) Schritt (b) umfaßt Positionieren der mehreren zusätzlichen Antennenelemente (10, 14) entlang einer Linie, die parallel zur Sendeantenne (16) ist und die Referenzachse an der Position des ersten Antennenelements schneidet, und Schritt (d) umfaßt Modifizieren der Signale unter Verwendung eines Leistungsteilers (18). der auch die Amplituden der Signale von jedem der zusätzlichen Antennenelemente (10, 14) mit einem Modifikationswert modifiziert; oder
(2) Schritt (b) umfaßt Positionieren von zwei zusätzlichen Antennenelementen, jeweils in Form eines ähnlichen Satzes von Schlitzen in einem Abschnitt eines Wellenleiters (38, 42) entlang einer Linie, die parallel zu der Sendeantenne (16) ist und die die Referenzachse in einer anderen Position schneidet als das erste identische Antennenelement (40), und Bereitstellen von Wellenleiterteilen (30), die so wirken, daß Signale von den anderen Antennenelementen (38, 42) mit Signalen von dem ersten Antennenelement (40) gekoppelt werden, so daß die Antennenelemente (38, 40, 42) eine Stehwellenantenne bilden, und Schritt (d) umfaßt Bereitstellen von vorbestimmten Phasenmodifikationswerten.

4. Verfahren zur Nahfeldbereichsüberwachung der Leistung einer Sendeantenne (16), mit folgenden Schritten:
(a) Positionieren einer Antennenelementeinrichtung (60) in einer Position innerhalb des Nahfeldbereichs der Antenne (16),
(b) Empfangen von HF-Signalen, die von der zu prüfenden Antenne abgestrahlt werden, über die Antennenelementeinrichtung (60);
(c) Modifizieren der Komponenten der Signale, die von der Antennenelementeinrichtung (60) empfangen wird, mit gewählten Modifikationswerte und Kombinieren der Signalkomponenten, um ein resultierendes Empfangssignal bereitzustellen, das sich dem Signal nähert, das im Fernfeld empfangen werden würde; und
(d) Überwachen des resultierenden empfangenen Signals;
wobei die Antennenelementeinrichtung aus einem einzelnen Antennenelement (60) besteht, das zur Verwendung mit einer Sendeantenne (16) eingerichtet ist, die einen Antennenstrahl bereitstellt, der über das Antennenelement (60) geführt wird.
wobei das Verfahren dadurch gekennzeichnet ist, daß der Schritt (b) Empfangen des Strahler-HF-Signals vom Sendesystem und ein Trennen der Gleichphasen- und der Quadraturkomponenten der Signale, die von der Antenneneinrichtung (60) empfangen werden, umfaßt und daß die Modifikation der Signalkomponenten deren zeitlich festgelegte Verarbeitung und Wichtung und anschließender Kombination der gewichteten Signalkomponenten auf der Grundlage einer Quadratwurzel der Summe der Quadrate umfaßt.

## Revendications

1. Un système de contrôle pour contrôler, en champ proche, le signal provenant d'une antenne d'émission (16), par l'utilisation de moyens de contrôle (20) et de moyens de modification (18; 30) se trouvant dans le champ proche pour recevoir le signal provenant de l'antenne d'émission, et pour appliquer aux moyens de contrôle un signal qui est une approximation de celui qui serait reçu dans le champ lointain, ce système de contrôle comprenant des éléments d'antenne (10, 12, 14; 38, 40, 42) pour coupler des composantes du signal émis, et des moyens de modification (18; 30) pour modifier certaines des composantes de signal et pour produire un signal combiné qui est transmis aux moyens de contrôle, ces éléments d'antenne (10, 12, 14; 38, 40, 42) comprenant
un premier élément d'antenne (12; 40) supporté en une position située sur un axe de référence qui est normal à l'antenne d'émission (16), pour coupler des composantes de signal sur l'axe, en champ proche, qui sont rayonnées le long de l'axe de référence;
un ensemble d'autres éléments d'antenne (10, 14; 38, 42), supportés dans des positions écartées symétriquement par rapport à l'axe de référence, pour coupler des signaux hors axe, en champ proche, qui sont rayonnés dans des positions écartées de l'axe de référence; et
les moyens de modification (18; 30) étant conçus pour soumettre les composantes de signal hors axe à des valeurs de modification de phase relatives sélectionnées. par rapport aux composantes de signal sur l'axe, et pour combiner les composantes de signal sur l'axe et les composantes de signal hors axe modifiées, de façon à produire l'approximation du signal en champ lointain,
ce système de contrôle étant caractérisé en ce qu'il est prévu pour l'utilisation avec une antenne d'émission qui produit un faisceau d'antenne balayant le premier élément d'antenne et les autres éléments d'antenne, et en ce que les moyens de modification (18; 30) produisent l'approximation du signal en champ lointain en n'utilisant ni une transformation de Fourier basée sur l'emploi d'un ordinateur, ni un réseau de formation de faisceau du type à matrice de Butler; et par l'une des structures suivantes:
(a) les moyens de modification consistent en un diviseur de puissance (18) et les autres éléments d'antenne (10, 14) s'étendent le long d'une ligne qui est parallèle à l'antenne d'émission (16) et qui coupe l'axe de référence à la position du premier élément d'antenne (12) sur l'axe de référence, et le diviseur de puissance (18) modifie également les amplitudes des composantes de signal hors axe; ou
(b) les moyens de modification consistent en deux sections de guide d'ondes (30) et le premier élément d'antenne (40) et les autres éléments d'antenne (38, 42) sont constitués seulement par trois éléments rayonnants, ayant chacun la forme d'un jeu de fentes similaire dans une partie de guide d'ondes, les autres éléments d'antenne (38, 42) s'étendant le long d'une ligne qui est parallèle à l'antenne d'émission (16) et qui coupe l'axe de référence en une position qui est différente de la position du premier élément d'antenne (40). et étant espacés de façon égale vis-à-vis du premier élément d'antenne (40) par les sections de guide d'ondes (30) qui produisent des valeurs de modification de phase prédéterminées et qui sont conçues pour coupler des signaux provenant des autres éléments d'antenne (38, 42) à des signaux provenant du premier élément d'antenne (40), grâce à quoi les éléments d'antenne (38. 40, 42) forment une antenne à ondes stationnaires, qui produit le signal combiné dans le premier élément d'antenne (40).

2. Un système de contrôle pour contrôler, en champ proche, le signal provenant d'une antenne d'émission (16). par l'utilisation de moyens de contrôle (64) et de moyens de modification (62) se trouvant dans le champ proche, pour recevoir le signal qui provient de l'antenne d'émission, et pour appliquer aux moyens de contrôle un signal qui est une approximation de celui qui serait reçu dans le champ lointain, ce système de contrôle comprenant une structure d'élément d'antenne (60) pour coupler le signal émis, et des moyens de modification (62) pour modifier et combiner des composantes de ce signal qui sont appliquées aux moyens de contrôle, dans lequel:
la structure d'élément d'antenne (60) qui est destinée à coupler des signaux en champ proche est positionnée sur un axe de référence qui est normal à l'antenne d'émission (16); et
les moyens de modification (62) sont conçus pour soumettre des composantes de ces signaux à des valeurs de modification sélectionnées, et pour combiner ensuite ces composantes de signaux pour produire l'approximation du signal en champ lointain; et
la structure d'élément d'antenne consiste en un seul élément d'antenne (60), le système est conçu pour l'utilisation avec une antenne d'émission (16) qui produit un faisceau d'antenne balayant l'élément d'antenne (60). et les moyens de modification comprennent des moyens de traitement de signal (62),
ce système de contrôle étant caractérisé en ce que les moyens de modification (62) sont conçus pour produire l'approximation en champ lointain en n'utilisant ni une transformation de Fourier basée sur l'emploi d'un ordinateur, ni un réseau de formation de faisceau du type matrice de Butler, et en ce que les moyens de traitement de signal (62) produisent les valeurs de modification par un traitement et une pondération dans le domaine temporel de composantes de signal, suivis par une combinaison des composantes de signal conformément à la racine carrée de la somme des carrés, les moyens de traitement de signal (62) recevant des signaux RF à partir de l'élément d'antenne (60) et le signal RF d'excitateur et séparant les composantes en phase et en quadrature qui sont pondérées et combinées conformément à la racine carrée de la somme des carrés, pour produire le signal qui constitue l'approximation du signal en champ lointain.

3. Un procédé pour le contrôle, dans une région de champ proche, des performances d'une antenne d'émission (16), comprenant les étapes suivantes:
(a) on positionne un premier élément d'antenne (12; 40) le long d'un axe de référence qui est normal à l'antenne d'émission (16), à un emplacement situé dans la région de champ proche de cette antenne (16);
(b) on positionne, à distance de l'axe de référence, un ensemble d'éléments d'antenne supplémentaires (10, 14; 38, 42), espacés transversalement et symétriquement par rapport au premier élément d'antenne (12; 40);
(c) on reçoit, par l'intermédiaire du premier élément d'antenne et des éléments d'antenne supplémentaires, les signaux qui sont rayonnés par l'antenne à tester;
(d) on modifie par une valeur de modification de phase les signaux qui sont reçus par chacun des éléments d'antenne supplémentaires (10. 14: 38, 42). cette valeur de modification de phase étant la même pour les signaux qui proviennent de chacun des éléments d'antenne supplémentaires (10, 14; 38, 42);
(e) on combine les signaux provenant du premier élément d'antenne (12: 40) et les signaux modifiés provenant de chacun des éléments d'antenne supplémentaires (10, 14; 38, 42), pour produire un signal reçu résultant qui constitue une approximation du signal qui aurait été reçu dans le champ lointain; et
(f) on contrôle (20) le signal reçu résultant;
ce procédé étant caractérisé par l'une des conditions suivantes:
(1) l'étape (b) comprend le positionnement de l'ensemble d'éléments d'antenne supplémentaires (10, 14) le long d'une ligne qui est parallèle à l'antenne d'émission (16) et qui coupe l'axe de référence à la position du premier élément d'antenne. et l'étape (d) comprend la modification des signaux par l'utilisation d'un diviseur de puissance (18) qui modifie également, par une valeur de modification, les amplitudes des signaux provenant de chacun des éléments d'antenne supplémentaires (10, 14); ou
(2) l'étape (b) comprend le positionnement de deux éléments d'antenne supplémentaires. ayant chacun la forme d'un jeu de fentes similaire dans une partie de guide d'ondes (38, 42), le long d'une ligne qui est parallèle à l'antenne d'émission (16) et qui coupe l'axe de référence en une position différente de celle du premier élément d'antenne identique (40), et l'incorporation de sections de guide d'ondes (30) qui couplent des signaux provenant des autres éléments d'antenne (38, 42) à des signaux provenant du premier élément d'antenne (40), de façon que les éléments d'antenne (38, 40, 42) forment une antenne à ondes stationnaires, et l'étape (d) comprend l'établissement de valeurs de modification de phase prédéterminées.

4. Un procédé pour le contrôle, dans une région de champ proche, des performances d'une antenne d'émission (16), comprenant les étapes suivantes:
(a) on positionne une structure d'élément d'antenne (60) en un emplacement situé dans la région de champ proche de l'antenne (16);
(b) on reçoit, par l'intermédiaire de la structure d'élément d'antenne (60), des signaux RF qui sont rayonnés par l'antenne à tester;
(c) on modifie, par des valeurs de modification sélectionnées, les composantes des signaux qui sont reçus par la structure d'élément d'antenne (60) et on combine ces composantes de signaux pour produire un signal reçu résultant qui constitue une approximation du signal qui aurait été reçu dans le champ lointain; et
(d) on contrôle le signal reçu résultant;
la structure d'élément d'antenne consistant en un seul élément d'antenne (60) qui est conçu pour être utilisé avec une antenne d'émission (16) qui produit un faisceau d'antenne balayant l'élément d'antenne (60).
ce procédé étant caractérisé en ce que l'étape (b) comprend la réception du signal RF d'excitateur provenant du système d'émission, et la séparation des composantes en phase et en quadrature des signaux qui sont reçus par la structure d'antenne (60), et en ce que la modification des composantes de signaux comprend leur traitement et leur pondération dans le domaine temporel, et ensuite la combinaison des composantes de signaux pondérées, conformément à la racine carrée de la somme des carrés.
